# EUROPÄISCHE PATENTSCHRIFT

(11) **EP 1 878 112 B1**
(45) Veröffentlichungstag und Bekanntmachung des Hinweises auf die Patenterteilung: **19.11.2008**
(21) Anmeldenummer: 06723824.6
(22) Anmeldetag: 29.03.2006
(51) Int. Cl.: H03K 5/02

(54) **SCHALTUNGSANORDNUNG SOWIE VERFAHREN ZUR ERZEUGUNG EINES RECHTECKSIGNALS**
CIRCUIT ARRANGEMENT AND METHOD FOR GENERATING A RECTANGULAR SIGNAL
ENSEMBLE CIRCUIT ET PROCEDE DE PRODUCTION D'UN SIGNAL RECTANGULAIRE

(30) Priorität: 29.03.2005 DE 102005015769
(43) Veröffentlichungstag der Anmeldung: 16.01.2008
(73) Patentinhaber: E.G.O. ELEKTRO-GERÄTEBAU GmbH, 75038 Oberderdingen (DE)
(72) Erfinder: KRAUS, Randolf, 75015 Bretten (DE)
(74) Vertreter: Patentanwälte Ruff, Wilhelm, Beier, Dauster & Partner
(86) Internationale Anmeldenummer: PCT/EP2006/002855
(87) Internationale Veröffentlichungsnummer: WO 2006/103052

(56) Entgegenhaltungen:
- EP-A- 1 035 651
- US-A- 4 016 476
- US-A- 4 149 232

## Beschreibung

### Anwendungsgebiet und Stand der Technik

Die Erfindung betrifft eine Schaltungsanordnung zur Erzeugung eines Rechtecksignals.

Bei elektronischen Schaltungen besteht häufig ein Bedarf an Rechtecksignalen, deren Amplitude größer ist als der Betrag einer Versorgungsspannung der elektronischen Schaltung.

Ein derartiges Rechtecksignal kann beispielsweise dadurch erzeugt werden, dass zusätzlich zu einer ersten Versorgungsspannungsquelle, beispielsweise mit einer Ausgangsspannung von 5V, eine zweite Spannungsquelle vorgesehen wird, beispielsweise mit einer Ausgangsspannung von 10V. Zur Erzeugung des Rechtecksignals, das zwischen einer Massespannung und 10V alterniert, wird zwischen die zweite Spannungsquelle und die Massespannung seriell ein Vorwiderstand und ein Transistor eingeschleift, der von einem mit 5V versorgten Mikroprozessor mit einem Rechtecksignal mit 5V Amplitude angesteuert wird. Die Ausgangsspannung liegt an einem Verbindungspunkt zwischen dem Vorwiderstand und dem Transistor an. Wenn der Transistor sperrt, liegt als Ausgangsspannung 10V abzüglich der am Vorwiderstand abfallenden Spannung an. Wenn der Transistor durchgeschaltet ist, liegt als Ausgangsspannung die Durchlassspannung des Transistors an, d.h. näherungsweise 0V. Aufgrund des Vorwiderstands ist der größere Wert der Ausgangsspannung jedoch stark lastabhängig, da ein Laststrom einen entsprechenden Spannungsabfall am Vorwiderstand bewirkt. Zur Verringerung dieser Lastabhängigkeit sollte der Vorwiderstand relativ niederohmig gewählt werden. Dies verursacht jedoch bei durchgeschaltetem Transistor einen hohen Strom, der ungenutzt über den Transistor nach Masse abfließt. Weiterhin ist eine zweite Spannungsquelle notwendig, wodurch der schaltungstechnische Aufwand, der Platzbedarf und die Herstellungskosten der Schaltungsanordnung zunehmen.

Die US 4,016,476 und die US 4,149,232 zeigen jeweils Spannungsverstärker, die zur Spannungsverstärkung Rechtecksignale erzeugen.

### Aufgabe und Lösung

Der Erfindung liegt als technisches Problem die Bereitstellung einer Schaltungsanordnung zur Erzeugung eines Rechtecksignals der eingangs genannten Art zugrunde, die ein Ausgangssignal mit geringerer Lastabhängigkeit bereitstellt und die kostengünstig bei geringem Platzbedarf realisierbar ist.

Die Erfindung löst dieses Problem durch eine Schaltungsanordnung mit den Merkmalen des Anspruchs 1. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

Erfindungsgemäß umfasst die Schaltungsanordnung zur Erzeugung eines Rechtecksignals eine Gleichspannungsquelle zur Erzeugung einer Gleichspannung, eine Treiberstufe, die zum wechselweisen Verbinden eines Steuerknotens mit einem Bezugspotential oder der Gleichspannung ausgebildet ist, eine Diode und einen ersten Kondensator, die seriell zwischen einen ersten Pol der Gleichspannungsquelle und den Steuerknoten eingeschleift sind. Des weiteren umfasst sie eine Ausgangsstufe mit einem ersten und einem zweiten ansteuerbaren Schaltmittel, die derart beschaltet sind, dass sie im Betrieb der Ausgangsstufe wechselweise leitend sind. Dabei sind die Schaltmittel seriell zwischen einen Verbindungsknoten zwischen der Diode und dem ersten Kondensator und den Steuerknoten eingeschleift. Ein Verbindungsknoten zwischen dem ersten und dem zweiten Schaltmittel bildet einen Ausgangsanschluss zur Ausgabe des Rechtecksignals bzw. an diesem steht das Rechtecksignal an. Die Treiberstufe, die Diode und der erste Kondensator bilden eine Spannungsverdopplereinheit, welche eine an der Treiberstufe erzeugbare Rechteckspannung, die zwischen der Gleichspannung und dem Bezugspotential alterniert, um den Betrag der Gleichspannung nach oben verschiebt. Dies bedeutet, dass sich an dem Verbindungspunkt zwischen der Diode und dem ersten Kondensator eine Rechteckspannung einstellt, die zwischen der Gleichspannung einerseits und in etwa dem doppelten der Gleichspannung andererseits alterniert. Die Ausgangsstufe wird mit dieser Rechteckspannung beaufschlagt.

Aufgrund der Beschaltung der Ausgangsstufe leitet das erste Schaltmittel, während das zweite Schaltmittel sperrt, wenn das verschobene Rechtecksignal seinen größeren Wert aufweist. Am Ausgangsanschluss steht dann folglich der größere Wert der verschobenen Rechteckspannung, d.h. in etwa die doppelte Gleichspannung an. Das erste Schaltmittel sperrt und das zweite Schaltmittel wird leitend, wenn das verschobene Rechtecksignal seinen kleineren Wert aufweist, d.h. in etwa gleich der Gleichspannung ist. Da das zweite Schaltmittel mit der Treiberstufe verbunden ist und diese momentan gegen das Bezugspotential durchgeschaltet ist, wird der Ausgangsanschluss ebenfalls gegen das Bezugspotential durchgeschaltet. Am Ausgangsanschluss entsteht folglich ein Ausgangssignal in Form einer Rechteckspannung, die in etwa zwischen der Bezugsspannung und der doppelten Gleichspannung alterniert. Dies wird erreicht, ohne dass hierzu eine weitere Spannungsquelle notwendig ist. Weiterhin weist das Ausgangssignal vorteilhaft nur eine geringe Lastabhängigkeit auf, da lediglich ein geringer Innenwiderstand des Ausgangsanschlusses aufgrund der niederohmigen Ankopplung über die Schaltmittel entsteht. Da keine zweite Spannungsquelle notwendig ist, kann die Schaltungsanordnung kostengünstig bei geringem Platzbedarf realisiert werden.

Das erste Schaltmittel ist ein erster bipolarer Transistor und das zweite Schaltmittel ist ein zweiter bipolarer Transistor. Durch die Verwendung bipolarer Transistoren ergibt sich aufgrund der Diodenstrecken zwischen der jeweiligen Basis und dem jeweiligen Emitter ein Spannungs-Klemmeffekt, der zur automatischen Ansteuerung der Transistoren verwendet werden kann. Dies bedeutet, dass sich bei geeigneter basisseitiger Beschaltung aufgrund der Diodenstrecken automatisch eine gewünschte Steuer- bzw. Basisspannung der Transistoren einstellt. Um eine derartige automatische Ansteuerung zu gewährleisten, sind als basisseitige Beschaltung bevorzugt zwischen einen Basisanschluss des ersten Transistors und das Bezugspotential ein Widerstand und ein zweiter Kondensator seriell eingeschleift, wobei der zweite Kondensator mit dem Bezugspotential verbunden ist. Dabei ist ein Verbindungsknoten zwischen dem Widerstand und dem zweiten Kondensator mit einem Basisanschluss des zweiten Transistors verbunden. Zusätzlich ist ein dritter Kondensator zwischen den Basisanschluss des ersten Transistors und das Bezugspotential eingeschleift. Der erste und der zweite Transistor sind komplementäre Transistoren. Auf diese Weise lässt sich einfach ein komplementäres Schaltverhalten der Transistoren bewirken.

In einer Ausbildung der Schaltungsanordnung umfasst diese einen Mikroprozessor, wobei die Treiberstufe ein Ausgangsanschluss des Mikroprozessors ist. Mit Hilfe eines Ausgangsanschlusses eines Mikroprozessors kann der Ausgangsanschluss entweder niederohmig mit der Bezugsspannung des Mikroprozessors oder mit dessen Versorgungsspannung verbunden werden. Dies bedeutet, dass am Ausgangsanschluss des Mikroprozessors in einfacher Weise eine Rechteckspannung in einem weiten Frequenzbereich erzeugt werden kann. Diese kann softwareseitig an gegebene Randbedingungen angepasst werden, beispielsweise die benötigte Frequenz der Rechteckspannung.

In einer Weiterbildung der Schaltungsanordnung ist zum Schutz der Treiberstufe ein Vorwiderstand zwischen dem Steuerknoten und der Treiberstufe vorgesehen. Der Vorwiderstand ist derart zu dimensionieren, dass eine Beschädigung des Anschlusses vermieden wird und gleichzeitig der resultierende Innenwiderstand des als Rechteckspannungsquelle dienenden Ausgangs gering genug bleibt, um eine zuverlässige Funktion der Schaltungsanordnung sicherzustellen.

Diese und weitere Merkmale gehen außer aus den Ansprüchen auch aus der Beschreibung und den Zeichnungen hervor, wobei die einzelnen Merkmale für sich allein oder zu mehreren in Form von Unterkombination bei einer Ausführungsform der Erfindung oder auf anderen Gebieten verwirklicht sein können und vorteilhafte sowie für sich schutzfähige Ausführungen darstellen können, für die hier Schutz beansprucht wird. Die Unterteilung der Anmeldung in einzelne Abschnitte sowie Zwischenüberschriften beschränken unter diesen gemachte Aussagen nicht in ihrer Allgemeingültigkeit.

### Kurzbeschreibung der Zeichnungen

Ein vorteilhaftes Ausführungsbeispiel der Erfindung ist in den Zeichnungen schematisch dargestellt und wird nachfolgend detailliert beschrieben. Hierbei zeigt:
- Fig. 1: eine Schaltbild einer Schaltungsanordnung zur Erzeugung eines Rechtecksignals und
- Fig. 2: ein Diagramm von Signalen der Schaltungsanordnung von Fig. 1.

### Detaillierte Beschreibung des Ausführungsbeispiels

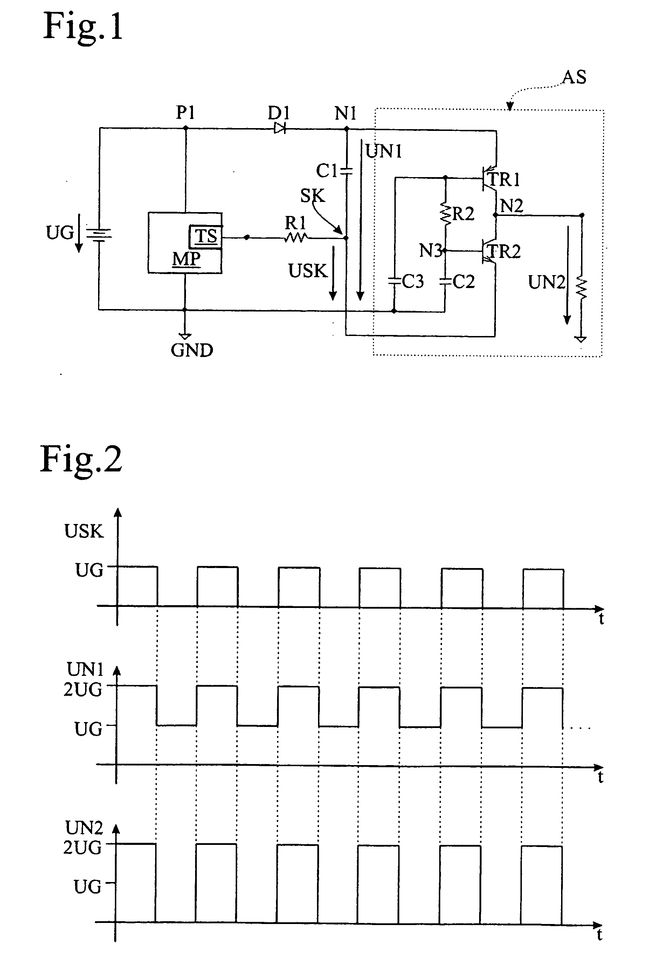

Fig. 1 zeigt eine Schaltungsanordnung zur Erzeugung eines Rechtecksignals UN2 mit einer Gleichspannungsquelle zur Erzeugung einer Gleichspannung UG, einem durch die Gleichspannung UG versorgten Mikroprozessor MP mit einem Ausgangsanschluss, der als Treiberstufe TS dient. Durch die Treiberstufe TS wird ein Steuerknoten SK wechselweise mit einem Bezugspotential GND oder der Gleichspannung UG verbunden. Es sind eine Diode D1 und ein erster Kondensator C1 vorgesehen, die seriell zwischen einen ersten Pol P1, hier der Plus-Pol, der Gleichspannungsquelle und den Steuerknoten SK eingeschleift sind. Ein Vorwiderstand R1 ist zwischen dem Steuerknoten SK und der Treiberstufe TS zum Schutz der Treiberstufe TS und zur Strombegrenzung bei Umschaltvorgängen des Treiberausgangs vorgesehen. Er wird jedoch niederohmig gewählt und bei der Funktionsbetrachtung vernachlässigbar ist. Schließlich ist noch eine Ausgangsstufe AS vorgesehen, die von dem rechten Teil der Schaltung gebildet wird.

Diese Ausgangsstufe AS umfasst einen bipolaren pnp-Transistor TR1 und einen komplementären bipolaren npn-Transistor TR2, die seriell zwischen einen Verbindungsknoten N1 zwischen der Diode D1 und dem ersten Kondensator C1 und den Steuerknoten SK eingeschleift sind. Ein Verbindungsknoten N2 zwischen den Transistoren TR1 und TR2 dient als Ausgangsanschluss zur Ausgabe des Rechtecksignals UN2. Zwischen einen Basisanschluss des Transistors TR1 und das Bezugspotential GND sind ein Widerstand R2 und ein zweiter Kondensator C2 seriell eingeschleift, wobei der zweite Kondensator C2 mit GND verbunden ist. Ein Verbindungsknoten N3 zwischen dem Widerstand R2 und dem zweiten Kondensator C2 ist mit einem Basisanschluss des zweiten Transistors TR2 verbunden. Zusätzlich ist ein dritter Kondensator C3 zwischen den Basisanschluss des ersten Transistors TR1 und das Bezugspotential GND eingeschleift. Der Kondensator C2 in, Verbindung mit R2, und der Kondensator C3 dienen zur automatischen Erzeugung der Basisspannungen der Transistoren TR1 bzw. TR2, d.h. die Kondensatoren C2 und C3 haben grundsätzlich die gleiche Funktion. Die Ausgangsstufe AS ist symmetrisch, d.h. die Transistoren TR1 und TR2 weisen ein symmetrisches Schaltverhalten auf.

Die Ausgangsstufe AS arbeitet im Gegentaktbetrieb, d.h. die Transistoren TR1 und TR2 werden abwechselnd leitend. Die Transistoren TR1 und TR2 werden in Basisschaltung betrieben. Die Basisspannungen der Transistoren TR1 und TR2 werden durch die Kondensatoren C2 und C3 und den Ladewiderstand R2 erzeugt. Die zum Betrieb erforderlichen Basisspannungen stellen sich automatisch ein, da sie durch die Klemmwirkung der Basis-Emitter-Strecke der Transistoren TR1 und TR2 begrenzt werden. Da die Transistoren TR1 und TR2 in einer symmetrischen Basisschaltung betrieben werden, hat die Ausgangsstufe AS eine hohe Bandbreite und ein symmetrisches Ausgangssignal U N2.

Fig. 2 zeigt ein Diagramm von Signalen der Schaltungsanordnung von Fig. 1. Die Treiberstufe TS, die Diode D1 und der erste Kondensator C1 bilden eine Spannungsverdopplerschaltung, welche eine an der Treiberstufe erzeugbare Rechteckspannung USK um den Betrag der Gleichspannung nach oben verschiebt. Die Rechteckspannung USK alterniert zwischen der Gleichspannung UG und dem Bezugspotential GND, wie in Fig. 2 gezeigt ist. Die derart verschobene, am Knoten N1 anliegende Rechteckspannung UN1 ist ebenfalls in Fig. 2 dargestellt. Die Spannung UN1 alterniert zwischen in etwa dem doppelten der Gleichspannung UG und dem Wert der Gleichspannung UG selber. Die an der Diode D1 abfallende Durchflussspannung wurde dabei vernachlässigt.

Die Ausgangsstufe AS wird mit der Rechteckspannung UN1 beaufschlagt. Aufgrund der Beschaltung der Ausgangsstufe AS leitet der Transistor TR1 und der Transistor TR2 sperrt, wenn die Spannung UN1 ihren größeren Wert aufweist, d.h. ca. 2 UG beträgt. Am Ausgangsanschluss steht dann folglich in etwa die doppelte Gleichspannung UG an.

Wenn die Spannung UN1 in etwa gleich der Spannung UG ist, sperrt der erste Transistor TR1 und der zweite Transistor TR2 wird leitend. Da der Transistor TR2 bzw. dessen Emitter mit der Treiberstufe TS verbunden ist, und diese momentan gegen das Bezugspotential GND durchgeschaltet ist, wird der Ausgangsanschluss bzw. der Knoten N2 ebenfalls gegen das Bezugspotential GND durchgeschaltet.

Am Knoten N2 entsteht folglich das in Fig. 2 gezeigte Ausgangssignal UN2 in Form einer Rechteckspannung, die in etwa zwischen der doppelten Gleichspannung UG und der Bezugsspannung GND alterniert.

Zusammenfassend wird nochmals das Funktionsprinzip der Schaltungsanordnung erläutert. Aus der Gleichspannung UG wird eine erste Rechteckspannung USK erzeugt, die zwischen der Gleichspannung UG und der Massespannung GND alterniert, wie in Fig. 2 gezeigt ist. Aus der ersten Rechteckspannung USK wird eine zweite Rechteckspannung UN1 erzeugt, die zwischen der Doppelten Gleichspannung UG und der Gleichspannung UG alterniert, wie ebenfalls in Fig. 2 gezeigt ist. Die zweite Rechteckspannung UN1 wird am Knoten N2 ausgegeben, wenn sie größer als die Gleichspannung UG, d.h. zweimal UG, ist. Andernfalls wird am Knoten N2 das Bezugspotential GND ausgegeben. Insgesamt entsteht am Knoten N2 die in Fig. 2 gezeigte Ausgangsspannung UN2.

Es ergibt sich folglich ein Ausgangsspannungshub von ca. zweimal UG, ohne dass hierzu eine weitere Spannungsquelle mit einer Ausgangsspannung von zweimal UG notwendig ist. Weiterhin weist das Ausgangssignal nur eine geringe Lastabhängigkeit auf, da lediglich ein geringer Innenwiderstand des Ausgangsanschlusses aufgrund der niederohmigen Ankopplung über die Schaltmittel entsteht. Da keine zweite Spannungsquelle notwendig ist, kann die Schaltungsanordnung kostengünstig bei geringem Platzbedarf realisiert werden.

## Patentansprüche

1. Schaltungsanordnung zur Erzeugung eines Rechtecksignals (UN2) mit
- einer Gleichspannungsquelle zur Erzeugung einer Gleichspannung (UG),
- einer Treiberstufe (TS), die zum wechselweisen Verbinden eines Steuerknotens (SK) mit einem Bezugspotential (GND) oder der Gleichspannung (UG) ausgebildet ist,
- einer Diode (D1) und einem ersten Kondensator (C1), die seriell zwischen einen ersten Pol (P1) der Gleichspannungsquelle und den Steuerknoten (SK) eingeschleift sind, und
- einer Ausgangsstufe (AS) mit einem ersten ansteuerbaren Schaltmittel (TR1) und einem zweiten ansteuerbaren Schaltmittel (TR2), die derart beschaltet sind, dass sie im Betrieb der Ausgangsstufe (AS) wechselweise leitend sind, wobei die Schaltmittel (TR1, TR2) seriell zwischen einen Verbindungsknoten (N1) zwischen der Diode (D1) und dem ersten Kondensator (C1) und den Steuerknoten (SK) eingeschleift sind und ein Verbindungsknoten (N2) zwischen dem ersten Schaltmittel (TR1) und dem zweiten Schaltmittel (TR2) einen Ausgangsanschluss zur Ausgabe des Rechtecksignals bildet,
**dadurch gekennzeichnet, dass**
- das erste Schaltmittel ein erster bipolarer Transistor (TR1) und das zweite Schaltmittel ein zweiter bipolarer Transistor (TR2) ist,
- der erste und der zweite Transistor komplementäre bipolare Transistoren sind und
- zwischen einen Basisanschluss des ersten Transistors und das Bezugspotential ein Widerstand (R2) und ein zweiter Kondensator (C2) seriell eingeschleift sind, wobei ein Verbindungsknoten (N3) zwischen dem Widerstand (R2) und dem zweiten Kondensator (C2) mit einem Basisanschluss des zweiten Transistors verbunden ist, und zusätzlich ein dritter Kondensator (C3) zwischen den Basisanschluss des ersten Transistors und das Bezugspotential eingeschleift ist.

2. Schaltungsanordnung nach Anspruch 1, **dadurch gekennzeichnet, dass** sie einen Mikroprozessor (MP) umfasst, wobei die Treiberstufe ein Ausgangsanschluss des Mikroprozessors ist.

3. Schaltungsanordnung nach Anspruch 1 oder 2, **dadurch gekennzeichnet, dass** zum Schutz der Treiberstufe ein Vorwiderstand (R1) zwischen dem Steuerknoten und der Treiberstufe vorgesehen ist.

## Claims

1. Circuit arrangement for generating a square wave signal (UN2) having
- a DC voltage source for generating a DC voltage (UG),
- a driver stage (TS) arranged for alternately coupling a control node (SK) to a reference potential (GND) or the DC voltage(UG),
- a diode (D1) and a first capacitor (C1) coupled in series between a first pole (P1) of the DC voltage source and the control node (SK), and
- an output stage (AS) with a first controllable switching means (TR1) and a second controllable switching means (TR2) wired in such a way that in operation of the output stage (AS) they are alternately conductive, wherein the switching means (TR1, TR2) being coupled in series between a connecting node (N1), formed between the diode (D1) and the first capacitor (C1), and the control node (SK), and wherein a connecting node (N2), formed between the first switching means (TR1) and the second switching means (TR2), forms an output terminal for emitting the square wave signal,
**characterized in that**
- the first switching means is a first bipolar transistor (TR1) and the second switching means is a second bipolar transistor (TR2),
- the first and second transistors are complimentary transistors, and
- between a base terminal of the first transistor and the reference potential a resistor (R2) and a second capacitor (C2) are coupled in series, wherein a connecting node (N3) between the resistor (R2) and the second capacitor (C2) is connected to a base terminal of the second transistor, and additionally a third capacitor (C3) is coupled between the base terminal of the first transistor and the reference potential.

2. Circuit arrangement according to claim 1, **characterized in that** it comprises a microprocessor (MP), the driver stage being an output terminal of the microprocessor.

3. Circuit arrangement according to claim 1 or 2, **characterized in that** a series resistor (R1) is provided between the control node and the driver stage for protecting the driver stage.

## Revendications

1. Ensemble circuit pour la génération d'un signal rectangulaire (UN2) présentant
- une source de tension continue pour la production d'une tension continue (UG),
- un étage pilote (TS) réalisé pour connecter à tour de rôle un noeud de commande (SK) avec un potentiel de référence (GND) ou bien avec une tension continue (UG),
- une diode (D1) et un premier condensateur (C1), qui sont bouclés en série entre un premier pôle (P1) de la source de tension continue et le noeud de commande (SK), et
- un étage de sortie (AS) avec un premier dispositif de commutation (TR1) commandable et un deuxième dispositif de commutation (TR2) commandable, qui sont branchés de telle manière qu'ils sont alternativement conductifs pendant le service de l'étage de sortie (AS), sachant que les dispositifs de commutation (TR1, TR2) sont bouclés en série entre un noeud de connexion (N1) situé entre la diode (D1) et le premier condensateur (C1) et le noeud de commande (SK) et qu'un noeud de connexion (N2) situé entre le premier dispositif de commutation (TR1) et le deuxième dispositif de commutation (TR2) constitue une borne de sortie pour la distribution du signal rectangulaire,
**caractérisé en ce que**
- le premier dispositif de commutation est un premier transistor bipolaire (TR1) et que le deuxième dispositif de commutation est un deuxième transistor bipolaire (TR2),
- le premier et le deuxième transistor sont des transistors bipolaires complémentaires et que
- une résistance (R2) et un deuxième condensateur (C2) sont bouclés en série entre une borne de base du premier transistor et le potentiel de référence, sachant qu'un noeud de connexion (N3) situé entre la résistance (R2) et le deuxième condensateur (C2) est branché à une borne de base du deuxième transistor, et qu'en outre un troisième condensateur (C3) est bouclé entre la borne de base du premier transistor et le potentiel de référence.

2. Ensemble circuit d'après la revendication 1, **caractérisé en ce qu'**il comprend un microprocesseur (MP), sachant que l'étage pilote est une borne de sortie du microprocesseur.

3. Ensemble circuit d'après la revendication 1 ou 2, **caractérisé en ce que** pour protéger l'étage pilote on prévoit une résistance série (R1) entre le noeud de commande et l'étage pilote.
